(19) Europäisches Patentamt
European Patent Office
Office européen des brevets

(11) **EP 2 997 175 B1**

(12) **EUROPÄISCHE PATENTSCHRIFT**

(45) Veröffentlichungstag und Bekanntmachung des Hinweises auf die Patenterteilung:
**07.03.2018 Patentblatt 2018/10**

(21) Anmeldenummer: **14721859.8**

(22) Anmeldetag: **06.05.2014**

(51) Int Cl.:
*C23C 16/442* *(2006.01)*        *C23C 16/24* *(2006.01)*
*C23C 16/44* *(2006.01)*          *C01B 33/035* *(2006.01)*
*B24C 1/00* *(2006.01)*

(86) Internationale Anmeldenummer:
**PCT/EP2014/059166**

(87) Internationale Veröffentlichungsnummer:
**WO 2014/184043 (20.11.2014 Gazette 2014/47)**

(54) **REAKTOR ZUR HERSTELLUNG VON POLYKRISTALLINEM SILICIUM UND VERFAHREN ZUR ENTFERNUNG EINES SILICIUM ENTHALTENDEN BELAGS AUF EINEM BAUTEIL EINES SOLCHEN REAKTORS**

REACTOR FOR PRODUCING POLYCRYSTALLINE SILICON AND METHOD FOR REMOVING A SILICON-CONTAINING LAYER ON A COMPONENT OF SUCH A REACTOR

RÉACTEUR DE PRODUCTION DE SILICIUM POLYCRISTALLIN ET PROCÉDÉ D'ÉLIMINATION D'UN DÉPÔT CONTENANT DU SILICIUM SUR UN COMPOSANT D'UN TEL RÉACTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.05.2013 DE 102013209076**

(43) Veröffentlichungstag der Anmeldung:
**23.03.2016 Patentblatt 2016/12**

(73) Patentinhaber: **Wacker Chemie AG**
**81737 München (DE)**

(72) Erfinder: **WECKESSER, Dirk**
**84561 Mehring (DE)**

(74) Vertreter: **Potten, Holger et al**
**Wacker Chemie AG**
**Zentralbereich Patente, Marken und Lizenzen**
**Hanns-Seidel-Platz 4**
**81737 München (DE)**

(56) Entgegenhaltungen:
**EP-A1- 2 583 943          WO-A1-01/25167**
**WO-A1-2012/008112       WO-A2-2008/022348**
**US-A- 4 500 492          US-A- 4 684 513**
**US-A1- 2006 089 258**

**Beschreibung**

Die Erfindung betrifft einen Reaktor zur Herstellung von polykristallinem Silicium sowie ein Verfahren zur Entfernung eines Silicium enthaltenden Belags auf einem Bauteil eines solchen Reaktors.

Polykristallines Silicium (kurz: Polysilicium) dient als Ausgangsmaterial zur Herstellung von einkristallinem Silicium für Halbleiter nach dem Czochralski(CZ)- oder Zonenschmelz(FZ)-Verfahren, sowie zur Herstellung von ein- oder multikristallinem Silicium nach verschiedenen Zieh- und Gieß-Verfahren zur Produktion von Solarzellen für die Photovoltaik.

Polykristallines Silicium wird in der Regel mittels des Siemens-Verfahrens hergestellt.

Bei diesem Verfahren werden in einem glockenförmigem Reaktor ("Siemens-Reaktor") Trägerkörper, üblicherweise dünne Filamentstäbe (Dünnstäbe) aus Silicium, durch direkten Stromdurchgang erhitzt und ein Reaktionsgas enthaltend Wasserstoff und eine oder mehrere Silicium enthaltende Komponenten eingeleitet.

Üblicherweise wird als Silicium enthaltende Komponente Trichlorsilan ($SiHCl_3$, TCS) oder eine Mischung von Trichlorsilan mit Dichlorsilan ($SiH_2Cl_2$, DCS) und/oder mit Tetrachlorsilan ($SiCl_4$, STC) eingesetzt. Auch die Verwendung von Monosilan ($SiH_4$) ist bekannt.

Die Dünnstäbe stecken üblicherweise senkrecht in am Reaktorboden befindlichen Elektroden, über die der Anschluss an die Stromversorgung erfolgt. Je zwei Dünnstäbe sind über eine waagrechte Brücke (ebenfalls aus Silicium) gekoppelt und bilden einen Trägerkörper für die Siliciumabscheidung. Durch die Brückenkopplung wird die typische U-Form der Trägerkörper erzeugt.

An den erhitzten Dünnstäben und der waagrechten Brücke scheidet sich hochreines Polysilicium ab, wodurch deren Durchmesser mit der Zeit anwächst.

Polykristallines Siliciumgranulat oder kurz Polysilicium-Granulat ist eine Alternative zum im Siemens-Verfahren hergestellten Polysilicium. Während das Polysilicium im Siemens-Verfahren als zylindrischer Siliciumstab anfällt, der vor seiner Weiterverarbeitung zeit- und kostenaufwändig zu so genanntem Chippoly zerkleinert und ggf. wiederum gereinigt werden muss, besitzt Polysilicium-Granulat Schüttguteigenschaften und kann direkt als Rohmaterial z. B. zur Einkristallerzeugung für die Photovoltaik- und Elektronikindustrie eingesetzt werden.

Polysilicium-Granulat wird in einem Wirbelschichtreaktor produziert. Dies geschieht durch Fluidisierung von Siliciumpartikeln mittels einer Gasströmung in einer Wirbelschicht, wobei diese über eine Heizvorrichtung auf hohe Temperaturen aufgeheizt wird. Durch Zugabe eines siliciumhaltigen Reaktionsgases erfolgt eine Pyrolysereaktion an der heißen Partikeloberfläche. Dabei scheidet sich elementares Silicium auf den Siliciumpartikeln ab und die einzelnen Partikel wachsen im Durchmesser an. Durch den regelmäßigen Abzug von angewachsenen Partikeln und Zugabe kleinerer Siliciumpartikel als Keimpartikel (Seed) kann das Verfahren kontinuierlich mit allen damit verbundenen Vorteilen betrieben werden. Derartige Abscheideverfahren und Vorrichtungen hierzu sind beispielsweise aus US 4786477 A bekannt.

Es hat sich gezeigt, dass es bei diesen Verfahren zu einer Siliciumabscheidung an den heißen Reaktorteilen, z. B. der Reaktorwand, Einbauteilen und Düsen - kommt. Es handelt sich dabei einerseits um auf den Reaktorteilen abgeschiedenes Silicium. Andererseits handelt es sich um Silicium-Staub, der auf heißen Reaktorteilen aufwächst.

US 20020102850 A1 offenbart ein Verfahren zur Vermeidung oder Entfernung von Siliciumabscheidung auf Eduktgasdüsen durch kontinuierliches, diskontinuierliches oder geregeltes Eindosieren von HCl + Inertgas ($H_2$, $N_2$, He, Ar) oder Inertgas $H_2$.

US 20020081250 A1 beschreibt ein Verfahren, bei dem ein Freiätzen oder teilweises Abätzen des Wandbelags bei Betriebstemperatur oder nahe der Betriebstemperatur des Wirbelschichtreaktors mit einem halogenhaltigen gasförmigen Ätzmittel, wie Chlorwasserstoff, Chlorgas oder Siliciumtetrachlorid erfolgt.

Allerdings ist eine solche Verfahrensführung mit erhöhten Betriebskosten verbunden.

US 7922990 B2 beansprucht ein Verfahren, bei dem in einem Reaktor mit einer heißen Oberfläche ein Reaktionsgas enthaltend eine gasförmige Siliciumverbindung bei einer Reaktionstemperatur von 600 bis 1100 °C als Siliciummetall auf Siliciumpartikeln, die mittels eines Fluidisierungsgases in einer Wirbelschicht fluidisiert und auf die Reaktionstemperatur erhitzt sind, abgeschieden wird und die mit dem abgeschiedenen Silicium versehenen Partikel sowie nicht reagiertes Reaktionsgas und Fluidisierungsgas aus dem Reaktor entfernt werden, dadurch gekennzeichnet, dass an der Oberfläche des Reaktors eine Gaszusammensetzung enthaltend 99,5 bis 95 Mol.% Wasserstoff und 0,5 bis 5 Mol.% der gasförmigen Siliciumverbindung vorliegt und die Oberfläche des Reaktors eine Temperatur von 700 bis 1400 deg. C aufweist und diese Temperatur der Temperatur der Siliciumpartikel entspricht oder höher liegt als die Temperatur der Siliciumpartikel.

Durch die Kombination einer hohen Reaktoroberflächentemperatur mit einer Gaszusammensetzung enthaltend 99,5 bis 95 Mol.% Wasserstoff und 0,5 bis 5 Mol.-% der gasförmigen Siliciumverbindung lässt sich an der Reaktoroberfläche ein Reaktionsgleichgewicht einstellen, bei dem eine Abscheidung von Silicium auf die Oberfläche des Reaktors nahezu nicht mehr stattfindet und daher eine kontinuierliche Verfahrensführung möglich ist.

US 2008299291 A1 offenbart, wie durch geeignete Wahl der Verfahrensparameter der mittleren Gasgeschwindigkeit in den beiden fluidisierten Zonen der Wirbelschicht, der lokalen Gasgeschwindigkeiten der Gase bzw. Gasgemische am Austritt der Düsensysteme, des Drucks und der Temperatur der Wirbelschicht, der Platzierung der Düsen relativ zueinander und relativ zur Wirbelschichtbewandung und der Verweilzeit der Gase in den fluidisierten Zonen der Wirbelschicht ein Reaktionsverlauf und damit ein Konzentrationsprofil erzeugt werden kann, welches gewährleistet, dass das Reaktionsgas nahezu bis zum chemischen Gleichgewichtsumsatz abreagiert ist, bevor es entweder die Wirbelschichtbewandung oder die Wirbelschichtoberfläche erreicht. Dadurch wird Wandabscheidung an der Wirbelschichtbewandung auf ein sehr geringes Maß reduziert, was die unbeeinträchtigte Beheizung der Wirbelschicht im Bereich der Reaktionszone über einen langen Zeitraum ermöglicht.

Somit scheint die Siliciumabscheidung auf der Reaktorwand durch geeignete Verfahrensführung reduziert werden zu können.

Dies gilt jedoch nicht für Beläge auf anderen Einbauteilen im Reaktor oder in Reaktornähe, wie Produktentnahmerohre oder Abgasrohre. Insbesondere gilt dies, wenn der Belag aus Si-Staub besteht, der aus der Wirbelschicht ausgetragen wird.

Auch hier wird im Stand der Technik Abätzen des Wandbelags empfohlen.

US 5358603 A offenbart ein Verfahren zum Ätzen eines Siliciumbelags auf einem Produktentnahmerohr, wobei der Reaktor heruntergefahren, der Siliciumbelag aufgeheizt und dann mit einer Mineralsäure wie HCl geätzt wird.

US 4,684,513 offenbart einen Wirbelschichtreaktor zur Herstellung von polykristallinem Silicium. Vor allem die Notwendigkeit, den Reaktor herunterzufahren, macht dieses Verfahren aufwändig und unwirtschaftlich. Zudem erhöhen sich die Betriebsmittelkosten.

Besonders problematisch ist die Tatsache, dass sich bei längerem Betrieb eines Wirbelschichtreaktors aufgrund einer Belagbildung die Wärmeübertragung im Abgaswärmeübertrager verschlechtert. Das Abgas kann nicht mehr ausreichend gekühlt werden. Auch bei CVD-Siemensreaktoren und deren Abgas (liebig) rohren ist der Fachmann mit ähnlichen Problemen konfrontiert. Aus der beschriebenen Problematik ergab sich die Aufgabenstellung der Erfindung.

Die Aufgabe wird gelöst durch ein Verfahren gemäß Anspruch 1 zur Entfernung eines Silicium enthaltenden Belags auf einem Bauteil eines Reaktors, in dem polykristallines Silicium hergestellt wird, dadurch gekennzeichnet, dass der Belag mechanisch mittels Silicium enthaltender Partikel entfernt wird.

Vorzugsweise weisen die Silicium enthaltenden Partikel eine mittlere Partikelgröße von 1 μm < $x_{50,3}$ < 400 μm auf, besonders bevorzugt 30 μm < $x_{50,3}$ < 300 μm. Vorzugsweise handelt es sich dabei um scharfkantige Partikel. Es hat sich gezeigt, dass die Entfernung des Wandbelags damit besonders effektiv erfolgt.

Die internationale Norm der "Federation Europeenne de la Manutention" gibt in der FEM 2581 einen Überblick, unter welchen Gesichtspunkten ein Schüttgut zu betrachten ist. In der Norm FEM 2582 werden die allgemeinen und spezifischen Schüttguteigenschaften hinsichtlich der Klassifizierung definiert. Kennwerte, die die Konsistenz und den Zustand des Gutes beschreiben sind zum Beispiel Kornform und Korngrößenverteilung (FEM 2.581 / FEM 2.582: General characteristics of bulk products with regard to their classification and their symbolization).

Auch können nach DIN ISO 3435 Schüttgüter in Abhängigkeit der Beschaffenheit der Kornkanten in 6 unterschiedliche Kornformen untergliedert werden:

I Scharfe Kanten mit ungefähr gleichen Ausmaßen in drei Dimensionen (Bsp.: Würfel)

II Scharfe Kanten, unter denen eine deutlich länger ist als die beiden anderen (Bsp.: Prisma, Klinge)

III Scharfe Kanten, unter denen eine deutlich kleiner ist als die anderen (Bsp.: Platte, Schuppen)

IV Runde Kanten mit ungefähr gleichen Ausmaßen in drei Dimensionen (Bsp.: Kugel)

V Faserig, fadenförmig, lockenförmig, verschlungen

Gemäß dieser Klassifizierung von Schüttgütern handelt es sich bei den Silicium enthaltenden Partikeln zur Entfernung des Wandbelags vorzugweise um Partikel der Kornformen I, II und III.

Die Partikel weisen vorzugsweise eine Sphärizität von kleiner als 0,9 auf.

Besonders bevorzugt weisen die Partikel eine Sphärizität von kleiner als 0,8 auf.

Die Sphärizität wird über dynamische Bildanalyse nach der Norm ISO/DIS 13322-2 bestimmt.

Die Sphärizität ist wie folgt definiert:

$$Sph = \frac{4 \cdot \pi \cdot A}{U^2},$$

mit der Projektionsfläche A und dem projizierten Umfang U des Partikels.

Eine weitere Kennzahl für die Kantigkeit der Partikel ist der sog. Rauhigkeitsgrad nach Jänke (Siegfried Jänke, Untersuchung der Zusammendrückbarkeit und Scherfestigkeit von Sanden und Kiesen sowie der sie bestimmenden Einflüsse = An investigation in the compressibility and shear strength of sands and gravels and in the influences governing them, Karlsruhe : Bundesanstalt für Wasserbau, 1969, Mitteilungsblatt der Bundesanstalt für Wasserbau, 28).

Die Partikel weisen gemäß dieser Definition vorzugsweise einen Rauhigkeitsgrad von größer als 0,6 auf.

Vorzugsweise wird zur Entfernung des Belags ein Ätzgas beigemischt.

Als Ätzgas eignet sich beispielsweise HCl.

Das Entfernen des Belags erfolgt in situ. Der Reaktor ist also in Betrieb und wird nicht heruntergefahren, um den Belag zu entfernen.

Vorzugsweise wird ein Abgaswärmeübertrager eines Reaktors vom Belag befreit. Diese kommen sowohl bei Wirbelschichtreaktoren als auch bei CVD-Siemensreaktoren zum Einsatz.

Beim Abgaswärmeübertrager handelt es sich vorzugsweise um ein Liebigrohr.

Dabei handelt es sich um ein an beiden Enden offenes Rohr, das von einem größeren Rohr umgeben ist. Zwischen innerem und äußerem Rohr fließt das Kühlwasser, im inneren Rohr strömt das Abgas.

Ebenso ist es bevorzugt, einen Mantelrohr-, Platten-, Rohrbündel-, Schicht- oder Spiralwärmeübertrager oder ein Kühlregister zu verwenden.

Beim Reaktor handelt es sich vorzugweise um einen CVD-Reaktor, um polykristallines Silicium auf Filamentstäben abzuscheiden.

Bei dem Reaktor handelt es sich um einen Wirbelschichtreaktor, um polykristallines Siliciumgranulat durch Abscheidung von polykristallinem Silicium auf dem Reaktor zugegebenen Silicium-Keimpartikeln herzustellen.

Die Silicium enthaltenden Partikel werden den Keimpartikeln (Seed) beigemischt und dabei dem Reaktor kontinuierlich zugeführt.

Der mittlere Durchmesser der Keimpartikel beträgt vorzugsweise mindestens 400 μm.

Alternativ können die Silicium enthaltenden Partikel in situ separat dem Reaktor zugeführt werden.

Vorzugsweise werden die Silicium enthaltenden Partikel in situ separat dem Reaktor zugeführt, wobei sie nach dem Kühlen durch einen Zyklon oder einen Oberflächenfilter zyklisch oder kontinuierlich vom Abgas getrennt und dann direkt nach dem Eintritt des staubigen Reaktorabgases in den Abgaswärmeübertrager zurückgeführt werden.

Bei den Silicium enthaltenden Partikeln handelt es sich im einfachsten Fall um reine Siliciumpartikel.

Siliciumpartikel mit den benötigten Partikelgrößen können durch Mahlung von hochreinem Silicium, z.B. von polykristallinem Siliciumgranulat, und anschließende Siebung bereitgestellt werden.

Bevorzugt ist aber auch der Einsatz von SiC-Partikeln.

Ebenso bevorzugt ist die Verwendung von $SiO_2$-Partikeln. Dabei kann es sich um Partikel aus der Verbrennung von Siliciumtetrachlorid zu hochdisperser Kieselsäure handeln.

Vorzugsweise wird der Abgaswärmeübertrager in Gleichstrom-, Gegenstrom- oder Kreuzstromfahrweise betrieben.

Dabei spielen die Parameter Partikelgröße, Geschwindigkeit, und Partikelform der Abreinigungspartikel und die Beladung des Abgasstroms mit Abreinigungspartikeln eine entscheidende Rolle.

Durch Zudosierung eines definierten Massenstromes an Partikeln mit einer definierten Partikelgröße und Partikelform, bei einer definierten Gasgeschwindigkeit wird die Bildung des Wandbelags überraschenderweise unterdrückt und somit die Kühlwirkung und ein ordnungsgemäßer Betrieb des Wirbelschichtreaktors erst ermöglicht.

Der mittlere Seedmassenstrom beträgt zwischen 0,5 und 15 kg/h. Der Feinanteil an scharfkantigen, abrasiven Partikeln im Seedmassenstrom bewegt sich zwischen 1 und 30 Gew.-%. Die Leerrohrgasgeschwindigkeit im Expansionskopf des Wirbelschichtreaktors beträgt zwischen 0,01 und 10 m/s, bevorzugt zwischen 0,1 und 1 m/s. Im Liebigrohr bildet sich eine Gasgeschwindigkeit zwischen 10 und 1000 m/s aus.

Die wesentlichen Vorteile des erfindungsgemäßen Verfahrens bestehen darin, dass das Entfernen des Wandbelags kontinuierlich während des Abscheideprozesses erfolgt.

Im Liebigrohr wird durch Entfernen des Belags sichergestellt, dass eine ausreichende Kühlung des Abgases erfolgt.

Das Entfernen des Belags erfolgt ohne Kontamination durch zusätzliche Stoffe.

Das Abgas kann für die nachfolgende Abgasfiltration heruntergekühlt werden. Es ist keine technisch aufwändige und kostenintensive Heißfiltration notwendig.

Es bedarf keiner weiteren bautechnischen Maßnahme, wenn die Partikel mit dem Seedmassenstrom über die Seeddosierrinne zugeführt werden und über die herkömmliche Kaltfiltration mit dem Abgasstaub aus dem Prozess ausgetragen werden.

Die Erfindung betrifft auch einen Reaktor gemäß Anspruch 8 zur Herstellung von polykristallinem Silicium, umfassend einen Reaktorbehälter (1), eine Vielzahl von Substraten aus Silicium innerhalb des Reaktorbehälters (1), geeignet, um polykristallines Silicium auf diesen abzuscheiden, eine oder mehrere Düsen (19, 20), um Reaktionsgas dem Reaktorbehälter (1) zuzuführen, eine Einrichtung zum Abführen von Reaktorabgas (9) aus dem Reaktorbehälter (1), einen Abgaswärmeüberträger (10) zum Kühlen des abgeführten Reaktorabgases sowie eine Zuführeinrichtung (16) für Silicium enthaltende Partikel, geeignet, um dem Abgaswärmeübertrager (10) Reaktorabgas und Silicium enthaltende Partikel zuzuführen. Vorzugsweise handelt es sich beim Reaktor um einen CVD-Reaktor zur Herstellung von polykristallinem Silicium in Stabform und bei den Substraten um Filamentstäbe aus Silicium, wobei eine Stromversorgung für die Filamentstäbe vorhanden ist, geeignet, um die Filamentstäbe durch direkten Stromdurchgang zu erhitzen. Beim Reaktor handelt es sich um einen Wirbelschichtreaktor zur Herstellung von granularem Polysilicium und bei den Substraten um Silicium-Keimpartikel, umfassend ein Innen-Reaktorrohr (2) für eine Wirbelschicht mit granularem Polysilicium und einen Reaktorboden innerhalb des Reaktorbehälters (1), eine Heizvorrichtung (5) zum Heizen der Wirbelschicht im Innen-Reaktorrohr (2), wenigstens eine Bodengasdüse (19) zur Zuführung von Fluidisierungsgas sowie wenigstens eine Reaktionsgasdüse (20) zur Zuführung von Reaktionsgas, eine Zuführeinrichtung (11), um Silicium-Keimpartikel zuzuführen sowie eine Entnahmeleitung (14) für granulares Polysilicium.

Vorzugsweise umfasst der Wirbelschichtreaktor weiterhin einen dem Abgaswärmeübertrager (10) nachgeschalteten Filter (21), geeignet, um Partikel und Gas zu trennen.

Vorzugsweise umfasst der Wirbelschichtreaktor weiterhin einen dem Abgaswärmeübertrager (10) nachgeschalteten Zyklon (24) zum kontinuierlichen Abtrennen von Partikeln vom Reaktorabgas, der mit einer Zuführeinrichtung (16) für Silicium enthaltende Partikel kommunikativ verbunden ist. Vorzugsweise umfasst der Wirbelschichtreaktor weiterhin einen dem Zyklon (24) nachgeschalteten Filter (26) zum Abtrennen von Reaktorabgasstaub (27).

**Beispiel**

Das nachfolgende Beispiel bezieht sich auf einen Wirbelschichtreaktor. Bei einem Verfahren zur Abscheidung von Polysilicium-Granulat mit einer Abscheiderate von 10 kg/h betrug die mittlere Seeddosierrate 1,5 kg/h. Im Seedmassenstrom waren 18 Gew.-% an scharfkantigen Silicium-Partikeln enthalten. Diese abrasiven Partikel wiesen eine mittlere Partikelgröße von $x_{50,3} = 125\ \mu m$, eine Sphärizität von 0,55 und einen Rauhigkeitsgrad von 0,74 auf. Die scharfkantigen Partikel wurden, verursacht durch die Leerrohrgasgeschwindigkeit im Expansionskopf des Wirbelschichtreaktors von 0,4 m/s, mit dem Abgasstrom aus dem Reaktor ausgetragen und entfernten kontinuierlich den Silicium enthaltenden Belag im Abgaswärmeübertrager. Die Gasgeschwindigkeit im Liebigrohr betrug 70 m/s. Der Abgaswärmeübertrager kühlte das Abgas von 700 °C auf 100 °C ab.

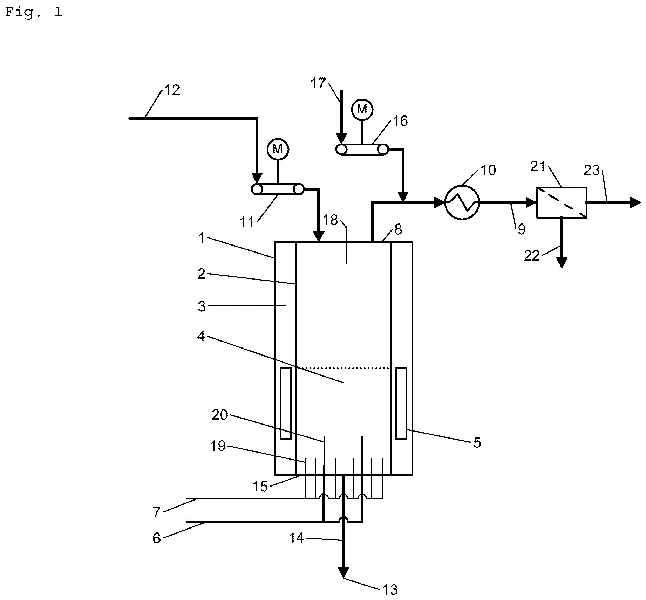

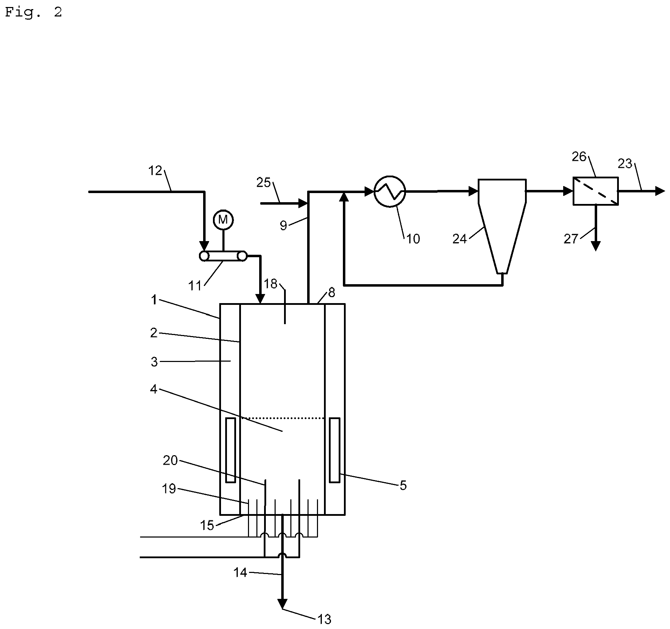

Die zur Durchführung des Verfahrens verwendete Vorrichtung wird nachfolgend anhand der **Fig. 1** und **2** erläutert.

**Kurzbeschreibung der Figuren**

**Fig. 1** zeigt schematisch eine bevorzugte Ausführungsform des im Rahmen der Erfindung eingesetzten Wirbelschichtreaktors.

**Fig. 2** zeigt einen Wirbelschichtreaktor.

**Liste der verwendeten Bezugszeichen**

| 1 | Reaktorbehälter |
|---|---|
| 2 | Innen-Reaktorrohr |
| 3 | Zwischenraum |
| 4 | Wirbelschicht |
| 5 | Heizvorrichtung |
| 6 | Reaktionsgasgemisch |
| 7 | Fluidisierungsgas |
| 8 | Reaktorkopf |
| 9 | Reaktorabgas |
| 10 | Abgaswärmeübertrager |
| 11 | Seedzuführeinrichtung |
| 12 | Seed |
| 13 | Produkt (Polysiliciumgranulat) |
| 14 | Entnahmeleitung |
| 15 | Reaktorboden |
| 16 | Zuführeinrichtung |
| 17 | Reinigungspartikel |
| 18 | Pyrometer |
| 19 | Bodengasdüsen |
| 20 | Reaktionsgasdüsen |
| 21 | Filter |
| 22 | Partikelstrom |
| 23 | Partikelfreier Gasstrom |
| 24 | Zyklon |
| 25 | Silicium enthaltende Partikel (Reinigungspartikel) |
| 26 | Filter |
| 27 | Reaktorabgasstaub |

Der Wirbelschichtreaktor besteht aus einem Reaktorbehälter **1**, in den ein Innen-Reaktorrohr **2** eingesetzt ist.

Zwischen der Innenwand des Reaktors und der Außenwand des Innenrohrs befindet sich ein Zwischenraum **3**.

Im Inneren des Reaktorrohres befindet sich die Wirbelschicht **4** mit dem Polysilicium-Granulat.

Die Wirbelschicht wird mittels einer Heizvorrichtung **5** geheizt.

Als Zugase werden dem Reaktor das Fluidisierungsgas **7** und das Reaktionsgasgemisch **6** zugeführt.

Die Gaszuführung erfolgt dabei gezielt über Düsen.

Das Fluidisierungsgas **7** wird über Bodengasdüsen **19** und das Reaktionsgasgemisch über sog. Sekundärgasdüsen (Reaktionsgasdüsen) **20** zugeführt.

Die Höhe der Sekundärgasdüsen kann sich von der Höhe der Bodengasdüsen unterscheiden.

Im Reaktor bildet sich durch die Anordnung der Düsen eine blasenbildende Wirbelschicht mit zusätzlicher vertikaler Sekundärgaseindüsung aus.

Am Reaktorkopf **8** ist ein Pyrometer **18** zur Messung der Wirbelschicht-Temperatur angebracht.

Über eine Seedzuführeinrichtung **11** wird dem Reaktor Seed **12** am Reaktorkopf zugeführt.

Das Polysilicium-Granulat-Produkt **13** wird über eine Entnahmeleitung **14** am Reaktorboden **15** entnommen.

Am Reaktorkopf **8** wird das Reaktorabgas **9** abgezogen und dem Abgaswärmeübertrager **10** zugeführt.

Vor dem Abgaswärmeübertrager werden dem Abgasstrom Silicium enthaltende Partikel **17** mittels einer Zuführeinrichtung **16** zugeführt.

Nach dem Abgaswärmeübertrager **10** wird das nun kalte Abgas über einen Filter **21** geführt.

Der Filter **21** trennt einen Partikelstrom **22,** der aus Reaktorabgasstaub und den für die Abreinigung zugeführten Partikeln **17** besteht, vom partikelfreien Gasstrom **23** ab.

**Fig. 1** zeigt eine vereinfachte Darstellung ohne Rückführung der für die Abreinigung verwendeten Partikel. Die Partikel werden in diesem Fall über den Abgasstaubfilter vom Gasstrom getrennt.

Eine weitere bevorzugte Ausführungsform ist in **Fig. 2** dargestellt.

Diese stellt eine Erweiterung der Apparatur um einen Zyklon **24** dar, der die für die Abreinigung verwendeten Partikel kontinuierlich aus dem Abgasstrom **9** entfernt und direkt nach dem Eintritt des staubigen Reaktorabgases in den Abgaswärmeübertrager **10** zurückgeführt.

Die Silicium enthaltenden Partikel **25** werden dem System einmalig zugegeben.

Nach dem Zyklon **24** durchläuft der mit Reaktorabgasstaub beladene Abgasstrom **9** einen Filter **26,** bei dem der Reaktorabgasstaub **27** vom partikelfreien Gasstrom **23** abgetrennt wird.

## Patentansprüche

1. Verfahren zur Entfernung eines Silicium enthaltenden Belags auf einem Bauteil eines Reaktors, wobei es sich beim Reaktor um einen Wirbelschichtreaktor handelt, um polykristallines Siliciumgranulat durch Abscheidung von polykristallinem Silicium auf dem Reaktor zugegebenen Silicium-Keimpartikeln herzustellen, wobei der Belag mechanisch mittels Silicium enthaltender scharfkantiger Partikel entfernt wird und das Entfernen des Belags erfolgt, während der Reaktor in Betrieb ist, also während polykristallines Siliciumgranulat hergestellt wird, **dadurch gekennzeichnet, dass** es sich beim Bauteil des Reaktors, auf dem der Belag entfernt wird, um ein Abgasrohr handelt und die Silicium enthaltenden Partikel zur Entfernung des Belags dem Wirbelschichtreaktor separat ohne Beimischung anderer Stoffe zugeführt werden oder die Silicium enthaltenden Partikel werden den Keimpartikeln beigemischt und dem Wirbelschichtreaktor kontinuierlich zugeführt.

2. Verfahren nach Anspruch 1, wobei es sich beim Abgasrohr um einen Abgaswärmeübertrager handelt.

3. Verfahren nach Anspruch 2, wobei es beim Abgaswärmeübertrager um ein Liebigrohr handelt.

4. Verfahren nach Anspruch 1, wobei die Silicium enthaltenden Partikel nach dem Kühlen in einem Abgaswärmeübertrager durch einen Zyklon oder einen Oberflächenfilter zyklisch oder kontinuierlich vom Abgas getrennt und dann direkt nach dem Eintritt des staubigen Reaktorabgases in den Abgaswärmeübertrager zurückgeführt werden.

5. Verfahren nach einem der Ansprüche 1 bis 4, wobei die Silicium enthaltenden Partikeln zur Entfernung des Belags eine mittlere Partikelgröße von $1 \ \mu m < x_{50,3} < 400 \ \mu m$, bevorzugt $30 \ \mu m < x_{50,3} < 300 \ \mu m$, aufweisen.

6. Verfahren nach einem der Ansprüche 1 bis 5, wobei es sich bei den Silicium enthaltenden Partikeln zur Entfernung des Belags um reines Silicium, um SiC oder um $SiO_2$ handelt.

7. Verfahren nach einem der Ansprüche 1 bis 6, wobei zur Entfernung des Belags ein Ätzgas beigemischt wird.

8. Reaktor zur Herstellung von polykristallinem Silicium, umfassend einen Reaktorbehälter (1), eine Vielzahl von Substraten aus Silicium innerhalb des Reaktorbehälters (1), geeignet, um polykristallines Silicium auf diesen abzuscheiden, eine oder mehrere Düsen (19, 20), um Reaktionsgas dem Reaktorbehälter (1) zuzuführen, eine Einrichtung zum Abführen von Reaktorabgas (9) aus dem Reaktorbehälter (1), einen Abgaswärmeüberträger (10) zum Kühlen des abgeführten Reaktorabgases sowie eine Zuführeinrichtung (16) für scharfkantige Silicium enthaltende Partikel, geeignet, um dem Abgaswärmeübertrager (10) Reaktorabgas und Silicium enthaltende Partikel zuzuführen, wobei es sich beim Reaktor um einen Wirbelschichtreaktor zur Herstellung von granularem Polysilicium und bei den Substraten um Silicium-Keimpartikel handelt, umfassend ein Innen-Reaktorrohr (2) für eine Wirbelschicht mit granularem Polysilicium und einen Reaktorboden innerhalb des Reaktorbehälters (1), eine Heizvorrichtung (5) zum Heizen der Wirbelschicht im Innen-Reaktorrohr (2), wenigstens eine Bodengasdüse (19) zur Zuführung von Fluidisierungsgas sowie wenigstens eine Reaktionsgasdüse (20) zur Zuführung von Reaktionsgas, eine Zuführeinrichtung (11), um Silicium-Keimpartikel zuzuführen sowie eine Entnahmeleitung (14) für granulares Polysilicium.

9. Reaktor nach Anspruch 8, weiterhin umfassend einen dem Abgaswärmeübertrager (10) nachgeschalteten Filter (21), geeignet, um Partikel und Gas zu trennen.

10. Reaktor nach Anspruch 8, weiterhin umfassend einen dem Abgaswärmeübertrager (10) nachgeschalteten Zyklon (24) zum kontinuierlichen Abtrennen von Partikeln vom Reaktorabgas, der mit einer Zuführeinrichtung (16) für Silicium enthaltende Partikel kommunikativ verbunden ist.

**11.** Reaktor nach Anspruch 10, weiterhin umfassend einen dem Zyklon (24) nachgeschalteten Filter (26) zum Abtrennen von Reaktorabgasstaub (27).

**Claims**

**1.** Method for removing a silicon-containing deposit on a component of a reactor, wherein the reactor is a fluidized-bed reactor for producing polycrystalline silicon granules by deposition of polycrystalline silicon on silicon seed particles added to the reactor, wherein the deposit is removed mechanically by means of silicon-containing sharp-edged particles and the deposit is removed while the reactor is in operation, that is to say while polycrystalline silicon granules are being produced, **characterized in that** the component of the reactor on which the deposit is removed is an off-gas tube and the silicon-containing particles, for removing the deposit, are fed to the fluidized-bed reactor separately without admixture of other substances or the silicon-containing particles are added to the seed particles and continuously fed to the fluidized-bed reactor.

**2.** Method according to Claim 1, wherein the off-gas tube is an off-gas heat exchanger.

**3.** Method according to Claim 2, wherein the off-gas heat exchanger is a Liebig tube.

**4.** Method according to Claim 1, wherein the silicon-containing particles, after the cooling in an off-gas heat exchanger, are cyclically or continuously separated from the off-gas by a cyclone or a surface filter and then returned to the off-gas heat exchanger directly after the entry of the dusty reactor off-gas.

**5.** Method according to any one of Claims 1 to 4, wherein the silicon-containing particles for removing the deposit have a median particle size of 1 $\mu$m < $x_{50.3}$ < 400 $\mu$m, preferably 30 $\mu$m < $x_{50.3}$ < 300 $\mu$m.

**6.** Method according to any one of Claims 1 to 5, wherein the silicon-containing particles for removing the deposit are pure silicon, SiC, or $SiO_2$.

**7.** Method according to any one of Claims 1 to 6, wherein an etching gas is admixed for removing the deposit.

**8.** Reactor for producing polycrystalline silicon, comprising a reactor vessel (1), a multiplicity of substrates of silicon within the reactor vessel (1) suitable for depositing polycrystalline silicon thereon, one or more nozzles (19, 20) in order to feed reaction gas to the reactor vessel (1), an appliance for removing reactor off-gas (9) from the reactor vessel (1), an off-gas heat exchanger (10) for cooling the reactor off-gas that is removed and also a feed appliance (16) for sharp-edged silicon-containing particles suitable for feeding reactor off-gas and silicon-containing particles to the off-gas heat exchanger (10), wherein the reactor is a fluidized-bed reactor for producing granular polysilicon and the substrates are silicon seed particles, comprising an inner reactor tube (2) for a fluidized bed having granular polysilicon and a reactor base within the reactor vessel (1), a heating device (5) for heating the fluidized bed in the inner reactor tube (2), at least one bottom gas nozzle (19) for feeding fluidizing gas, and at least one reaction gas nozzle (20) for feeding reaction gas, a feed appliance (11) for feeding silicon seed particles, and a take-off conduit (14) for granular polysilicon.

**9.** Reactor according to Claim 8, additionally comprising a filter (21) connected downstream of the off-gas heat exchanger (10) and suitable for separating particles and gas.

**10.** Reactor according to Claim 8, additionally comprising a cyclone (24) connected downstream of the off-gas heat exchanger (10) for continuous separation of particles from the reactor off-gas and which is communicatively connected to a feed appliance (16) for silicon-containing particles.

**11.** Reactor according to Claim 10, additionally comprising a filter (26) connected downstream of the cyclone (24) for separating off reactor off-gas dust (27).

**Revendications**

**1.** Procédé d'élimination d'un revêtement contenant du silicium sur un composant d'un réacteur, le réacteur étant un réacteur à lit fluidisé, afin de fabriquer un granulat de silicium polycristallin par dépôt de silicium polycristallin sur des particules germes de silicium ajoutées au réacteur, le revêtement étant éliminé mécaniquement au moyen de particules à arêtes vives contenant du silicium, et l'élimination du revêtement ayant lieu pendant que le réacteur est en exploitation, c'est-à-dire pendant que le granulat de silicium polycristallin est fabriqué, **caractérisé en ce que** le composant du réacteur duquel le revêtement est éliminé est un tube de gaz d'échappement et les particules contenant du silicium pour l'élimination du revêtement sont introduites séparément dans le réacteur à lit fluidisé sans incorporation d'autres substances, ou les particules contenant du silicium sont mélangées avec les particules germes et introduites en continu dans le réacteur à lit fluidisé.

2. Procédé selon la revendication 1, dans lequel le tube de gaz d'échappement est un échangeur de chaleur pour le gaz d'échappement.

3. Procédé selon la revendication 2, dans lequel l'échangeur de chaleur pour le gaz d'échappement est un tube Liebig.

4. Procédé selon la revendication 1, dans lequel les particules contenant du silicium sont séparées du gaz d'échappement de manière cyclique ou continue après le refroidissement dans un échangeur de chaleur à gaz d'échappement par un cyclone ou un filtre de surface, puis recyclées directement après l'entrée du gaz d'échappement de réacteur poussiéreux dans l'échangeur de chaleur pour le gaz d'échappement.

5. Procédé selon l'une quelconque des revendications 1 à 4, dans lequel les particules contenant du silicium pour l'élimination du revêtement présentent une taille de particule moyenne de 1 $\mu$m < $x_{50,3}$ < 400 $\mu$m, de préférence de 30 $\mu$m < $x_{50,3}$ < 300 $\mu$m.

6. Procédé selon l'une quelconque des revendications 1 à 5, dans lequel les particules contenant du silicium pour l'élimination du revêtement sont du silicium pur, du SiC ou du $SiO_2$.

7. Procédé selon l'une quelconque des revendications 1 à 6, dans lequel un gaz d'attaque est incorporé pour l'élimination du revêtement.

8. Réacteur pour la fabrication de silicium polycristallin, comprenant un contenant de réacteur (1), une pluralité de substrats en silicium dans le contenant de réacteur (1), appropriés pour le dépôt de silicium polycristallin sur ceux-ci, une ou plusieurs buses (19, 20) pour l'introduction d'un gaz de réaction dans le contenant de réacteur (1), un dispositif pour le déchargement d'un gaz d'échappement de réacteur (9) du contenant de réacteur (1), un échangeur de chaleur pour le gaz d'échappement (10) pour le refroidissement du gaz d'échappement de réacteur déchargé, ainsi qu'un dispositif d'alimentation (16) pour des particules contenant du silicium à arêtes vives, approprié pour l'introduction du gaz d'échappement de réacteur et des particules contenant du silicium dans l'échangeur de chaleur pour le gaz d'échappement (10), le réacteur étant un réacteur à lit fluidisé pour la fabrication de polysilicium granulaire et les substrats étant des particules germes de silicium, comprenant un tube de réacteur intérieur (2) pour un lit fluidisé contenant du polysilicium granulaire et un fond de réacteur dans le contenant de réacteur (1), un dispositif de chauffage (5) pour le chauffage du lit fluidisé dans le tube de réacteur intérieur (2), au moins une buse de gaz de fond (19) pour l'introduction d'un gaz de fluidisation, ainsi qu'au moins une buse de gaz de réaction (20) pour l'introduction d'un gaz de réaction, un dispositif d'alimentation (11) pour l'introduction de particules germes de silicium, ainsi qu'une conduite de soutirage (14) pour le polysilicium granulaire.

9. Réacteur selon la revendication 8, comprenant en outre un filtre (21) en aval de l'échangeur de chaleur pour le gaz d'échappement (10), approprié pour séparer les particules et le gaz.

10. Réacteur selon la revendication 8, comprenant en outre un cyclone (24) en aval de l'échangeur de chaleur pour le gaz d'échappement (10) pour la séparation continue de particules du gaz d'échappement de réacteur, qui communique avec un dispositif d'alimentation (16) pour les particules contenant du silicium.

11. Réacteur selon la revendication 10, comprenant en outre un filtre (26) en aval du cyclone (24) pour la séparation de la poussière du gaz d'échappement de réacteur (27).

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4786477 A
- US 20020102850 A1
- US 20020081250 A1
- US 7922990 B2
- US 2008299291 A1
- US 5358603 A
- US 4684513 A